# EUROPEAN PATENT SPECIFICATION

(11) **EP 0 342 933 B1**
(45) Date of publication and mention of the grant of the patent: **18.09.1996**
(21) Application number: 89304948.6
(22) Date of filing: 16.05.1989
(51) Int. Cl.: H01J 37/317, H01J 37/20, H01L 21/00

(54) **Disk scanning apparatus for batch ion implanters**
Gerät zur Abrasterung einer Tragplatte in einer Schub-Ionen-Implantierungsanlage
Appareil de balayage de disque-support pour implanteurs ioniques par fournées

(30) Priority: 18.05.1988 US 195729
(43) Date of publication of application: 23.11.1989
(73) Proprietor: VARIAN ASSOCIATES, INC., Palo Alto, CA 94303 (US)
(72) Inventor: Freytsis, Avrum, Swampscott, MA 01907 (US); Hertel, Richard John, Boxford, MA 01921 (US); Mears, Eric L., Rockport, MA 01966 (US)
(74) Representative: Cline, Roger Ledlie

(56) References cited:
- US-A- 3 983 402
- US-A- 4 419 584
- US-A- 4 733 091
- US-A- 4 745 287
- NUCLEAR INSTRUMENTS & METHODS IN PHYSICS RESEARCH, SECTION B vol. 37/38, no.2, February 1989, AMSTERDAM pages 533 - 537; B. LIEBERT et al.: "The Extrion 1000: a new high current ion implantation system for automated fabrication environments and intelligent process control"

## Description

This invention relates to apparatus for vacuum processing of workpieces and, more particularly, to apparatus for mechanically scanning, or translating, a plurality of workpieces in two dimensions relative to an ion beam so that ions are uniformly distributed over the workpiece surface. The scanning system is intended primarily for ion implantation of semiconductor wafers, but is not limited to such use.

Ion implantation has become a standard, commercially-accepted technique for introducing conductivity-altering impurities into semiconductor wafers. The desired impurity material is ionized in an ion source, the ions are accelerated to form an ion beam of prescribed energy, and the ion beam is directed at the surface of the semiconductor wafer. The energetic ions in the beam penetrate into the bulk of the semiconductor material and are embedded in the crystalline lattice of the semiconductor material to form a region of desired conductivity.

In commercial ion implanters, several factors are crucial in achieving an effective system. One crucial factor is throughput in terms of wafers processed per unit time. Wafer transfer time, implant time and downtime all contribute to the total processing time. In order to reduce the implant time, efforts are constantly made to increase the ion beam current applied to the semiconductor wafer while maintaining the wafer below a prescribed maximum temperature. Other crucial factors in ion implantation include dose accuracy and dose uniformity over the surface of the wafer, since semiconductor devices fabricated by ion implantation must have controlled and repeatable operating characteristics. Furthermore, minimizing particulate contamination is extremely important, since semiconductor devices with microminiature features are extremely susceptible to damage by such contamination.

Ion implanters have generally fallen into two major categories, serial and batch. In serial systems, wafers are processed one at a time. Since the wafer is continuously in the ion beam during implantation, the maximum ion beam current is limited. In batch systems, a number of semiconductor wafers are typically mounted on wafer mounting sites in an annular region near the periphery of a disk. The disk intercepts the ion beam in a small area of the annular region, and the disk is rotated so that all of the wafers successively intercept the ion beam. Since each individual wafer intercepts the ion beam for only a fraction of the disk revolution time, the average power applied to each wafer is relatively low. As a result, significantly higher ion beam currents can be utilized in batch systems than in serial systems. Since the ion beam is typically smaller in cross-section than the surface area of a wafer, it is necessary to provide additional movement, either of the rotating disk or of the beam, in order to uniformly distribute ions over the wafer surface.

In one prior art batch ion implanter, the ion beam is magnetically scanned in one direction, and disk rotation provides movement in a second direction. Such a system is disclosed in US-A- 4,276,477 issued June 30, 1981 to Enge. One disadvantage of magnetic beam scanning is that the required scan magnets are large and heavy.

A second approach to batch ion implantation has been to utilize a stationary ion beam and mechanical scanning of the wafers in two dimensions. However, two-dimensional mechanical scanning in vacuum is difficult because the drive mechanisms are preferably located outside the vacuum chamber for operational reasons and to prevent contamination generated by moving mechanical parts. A two-dimensional mechanical scan system for ion implantation is disclosed in US-A- 3,983,402 issued September 28, 1976 to Arndt, Jr. et al. The disclosed system utilizes a pair of bellows for transmitting reciprocating motion into the vacuum chamber. Another prior art system that utilizes a rotating disk and a sliding seal, or linear air bearing, to provide reciprocating motion of the rotating disk relative to the ion beam is described in US-A- 4,299,655 issued October 21, 1980 to Ryding. Still another prior system for providing two-dimensional motion is described in EPA- 0,178,803 published April 23, 1986. A rotating disk is carried on an arm that precesses back and forth in an arc within the vacuum chamber.

A further complication in batch ion implantation systems is that provision must be made for loading wafers onto the disk prior to implantation and for removing wafers from the disk after implantation is complete. Wafer exchange is preferably performed automatically in a manner which reduces the possibility of particulate contamination to a minimum. In one wafer loading technique, the disk is flipped or pivoted from a more-or-less vertical orientation during implantation to a horizontal orientation for loading and unloading of wafers. This technique is utilized in the Varian Model 160-10 Ion Implanter and is shown in US-A-4,276,477; US-A-3,983,402; and US-A-4,299,655. In another technique disclosed in EP-A-0,178,803, the disk is maintained in the implant position during loading and unloading of wafers.

US-A-4,745,287 discloses apparatus for workpiece translation comprising a vacuum envelope defining a vacuum chamber, a disk including a plurality of workpiece mounting sites, said disk being positioned within the vacuum chamber, disk drive means within said vacuum chamber for rotating the disk about a disk rotation axis and pivot drive means for pivoting said disk drive means and said disk about a pivot axis to and between a treatment position and a load/unload position for loading and unloading of workpieces. The present invention improves on this arrangement by providing scan arm means for supporting said disk and said disk drive means, said scan arm means extending through the vacuum envelope and being mounted for movement about a scan axis, together with scan drive means for scanning said scan arm means about the scan axis so that the disk and the disk drive means move along an arc-shaped path in said vacuum chamber, said pivot drive means pivoting said scan arm means with said disk drive means and said disk about said pivot axis which is perpendicular to said disc rotation axis.

An example of the invention will now be described with reference to the accompanying drawings in which:
Figure 1 is a top plan view, partially broken away, of an ion implantation system with the disk shown in a horizontal position for loading and unloading of wafers;
Figure 2 is an elevation view of the ion implantation system of Figure 1, as seen along the line 2-2 of Figure 1, with the disk shown in an implant position;
Figure 3 is a perspective view of the scanning apparatus of the present invention with the disk access door open;
Figure 4 is a cross-sectional view of the scanning apparatus taken along line 4-4 of Figure 2;
Figure 5 is a cross-sectional view of the scanning apparatus taken along the line 5-5 of Figure 4 showing the scan drive assembly and the pivot drive assembly;
FIG. 6 is a cross-sectional view of the scanning apparatus taken along the line 6-6 of FIG. 4 showing the access door assembly and the implant angle adjustment;
FIG. 7 is a cross-sectional view of the scanning apparatus taken along the line 7-7 of FIG. 5 showing the scan drive assembly;
FIG. 8 is a partial cross-sectional view of the scanning apparatus taken along the line 8-8 of FIG. 6 showing the implant angle adjustment;
FIG. 9 is a partial cross-sectional view of the scanning apparatus taken along the line 9-9 of FIG. 8 showing the implant angle adjustment;
FIG. 10 is a cross-sectional view of the scanning apparatus taken along the line 10-10 of FIG. 4, showing the disk in the implant position in solid lines and in the load/unload position in phantom lines;
FIG. 11 is a cross-sectional view of the disk drive assembly taken along the lines 11-11 of FIG. 10;
FIG. 12 is a cross-sectional view of the disk drive assembly taken along the lines 12-12 of FIG. 11;
FIG. 13 is a schematic view of the scanning apparatus that illustrates scan arm operation; and
FIG. 14 is a schematic diagram illustrating the interrelationship of the axes of movement of the scanning apparatus.

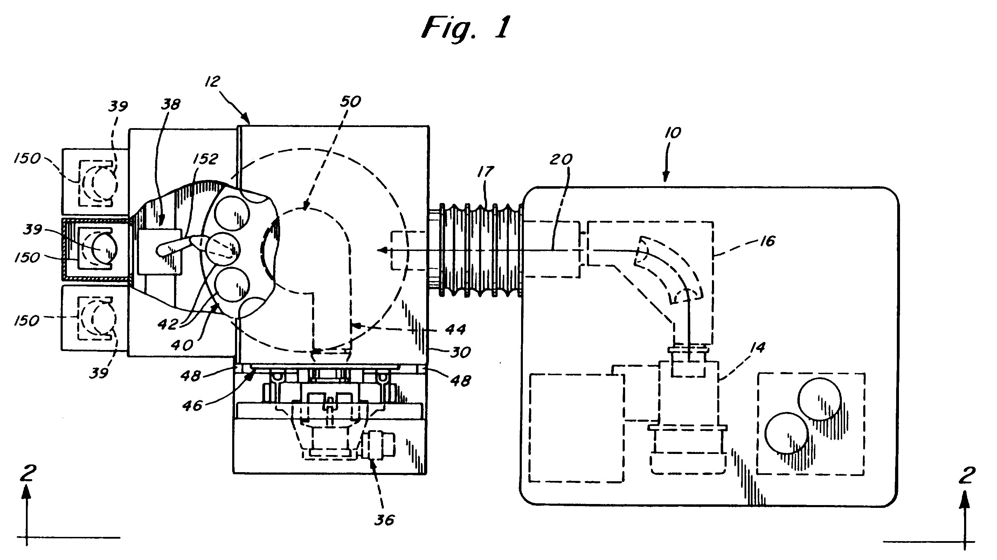

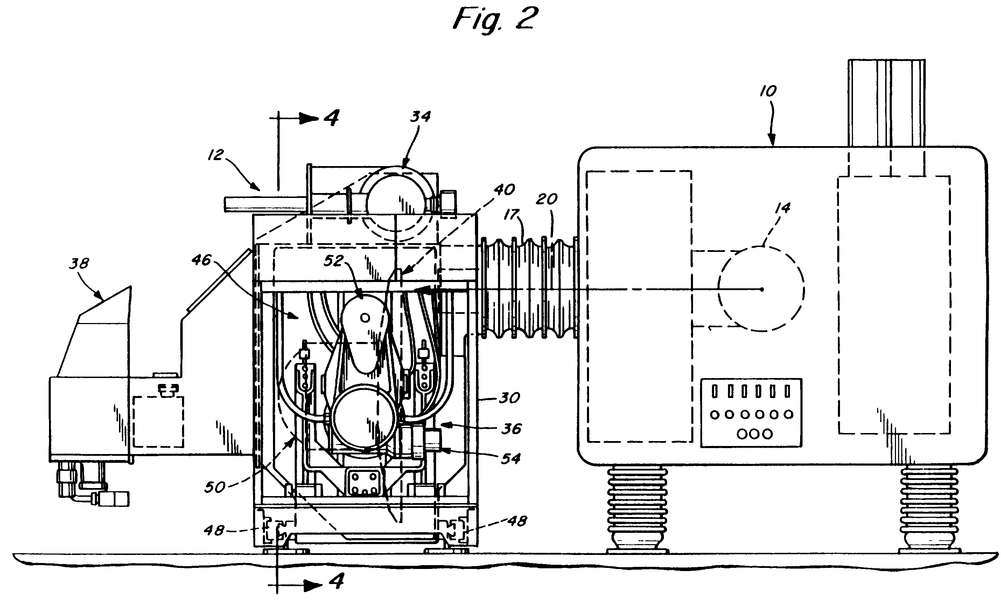

An ion implantation system shown in FIGS. 1 and 2 includes a terminal module 10 and an end station module 12. The terminal module 10 includes an ion source 14 for ionizing a source material and forming an ion beam 20, a mass analyzer 16 for separating undesired species from ion beam 20, and an accelerator 17 for accelerating the ion beam 20 to energies in the range between 2 keV and 200 keV. The ion source 14 may produce ion beam currents up to 30 milliamps. The ion beam 20 is fixed in position along a prescribed axis and is directed into the end station module 12.

The end station module 12 includes a high vacuum chamber 30. The vacuum chamber 30 is maintained at high vacuum by a vacuum pumping system 34. The end station module 12 includes scanning apparatus 36 in accordance with the present invention for translating, or scanning, of workpieces, usually semiconductor wafers, in two dimensions relative to the ion beam 20. The end station module 12 also includes a wafer transfer system 38 for loading semiconductor wafers 39 onto the scanning apparatus 36 prior to ion implantation and for unloading the wafers from the scanning apparatus 36 after ion implantation. The region surrounding ion beam 20 from ion source 14 to wafers 39 is maintained at high vacuum during operation.

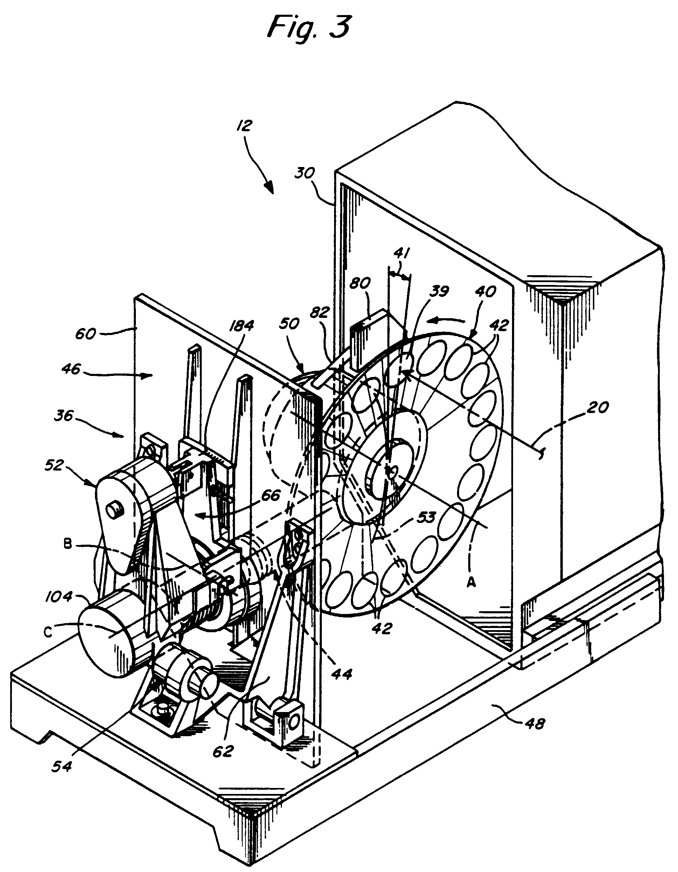

A perspective view of the scanning apparatus 36 is shown in FIG. 3. The scanning apparatus 36 includes a disk 40 having a plurality of wafer mounting sites 42 located in an annular region near its outer periphery. The disk 40 is mounted to a disk drive assembly 50. The disk 40 and the disk drive assembly 50 are supported by a scan arm assembly 44 which is mounted to an access door assembly 46. The access door assembly 46 is supported by a pair of rails 48 which extend under vacuum chamber 30 in a direction transverse to ion beam 20. The access door assembly 46, the disk 40, the disk drive assembly 50 and the scan arm assembly 44 can be moved outwardly on rails 48 for access to these elements.

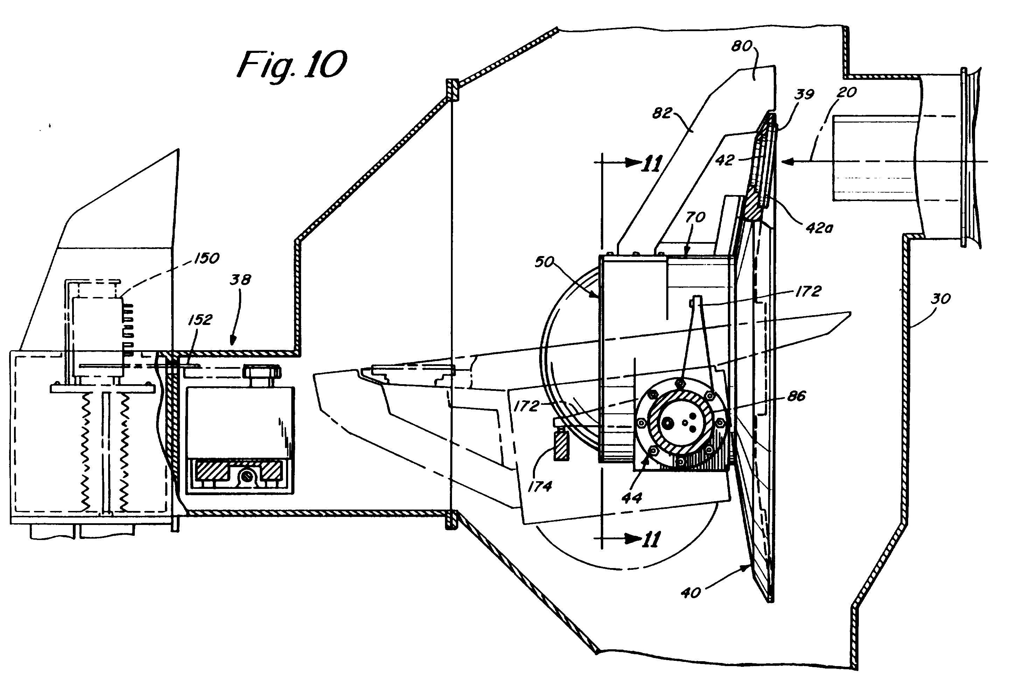

The disk 40 is caused to rotate about a disk rotation axis A through its center by the disk drive assembly 50. The disk 40, the disk drive assembly 50 and the scan arm assembly 44 are caused by a scan drive assembly 52 to reciprocate, or scan, in an arc 53 about a scan axis B. The rotation of disk 40 about axis A and the scanning of scan arm assembly 44 about axis B provide a composite two-dimensional motion relative to ion beam 20 so that the surface of each wafer mounted on disk 40 receives a uniform ion dosage. The disk 40 is also movable between an approximately vertical ion implant position (shown in solid lines in FIG. 10) and an approximately horizontal load/unload position (shown in phantom in FIG. 10). The disk 40 and the disk drive assembly 50 are caused to pivot about a pivot axis C between the implant position and the load/unload position by a pivot drive assembly 54. In addition to the above movements, the disk 40, the disk drive assembly 50, the scan arm assembly 44 and the scan drive assembly 52 can be manually rotated about the axis C in order to change the implant angle, as described hereinafter.

The access door assembly 46, as shown in FIGS. 3, 4 and 6, includes a disk access door 60 having an inside surface 60a that is sealed vacuum tight to an opening in vacuum chamber 30. An elastomer ring 61 is used to seal the door 60 to vacuum chamber 30 A door support 62 is coupled between the outside surface of access door 60 and rails 48 in order to strengthen and stabilize the access door 60. The access door assembly 46 further includes vertical adjustment screws 63 for adjusting the vertical position of door 60 on rails 48, horizontal adjustment screws 65 for adjusting the horizontal position of the door 60 on rails 48 and a rotational adjustment 67 for door 60.

As described hereinafter, the disk 40, the disk drive assembly 50, the scan arm assembly 44 and the scan drive assembly 52 are supported by the access door 60. The access door 60 further includes an opening 64 through which the scan arm assembly 44 passes. The disk end, or inner end, of the scan arm assembly 44 is inside vacuum chamber 30, while the drive end, or outer end, thereof is located outside the vacuum chamber 30. A scan support 66 is mounted to the outside of access door 60 in a manner which permits rotation of the scanning apparatus 36 about axis C, as described hereinafter.

As described hereinabove, wafer mounting sites 42 are located in an annular region near the periphery of disk 40, as shown in FIGS. 3, 10 and 12. Each wafer mounting site 42 includes a flat surface 42a on which a wafer is mounted and which acts as a heat sink for energy transferred to the wafer by the ion beam 20 The wafer mounting surfaces 42a are each tilted at a prescribed angle 41, typically seven degrees, relative to the plane of disk 40. As a result, when the disk 40 rotates about the axis A, which is perpendicular to the disk plane, centrifugal force presses the wafers against the respective mounting surfaces 42a. Each wafer mounting site 42 is preferably cooled by water circulated through the scan arm assembly 44 and the disk drive assembly 50.

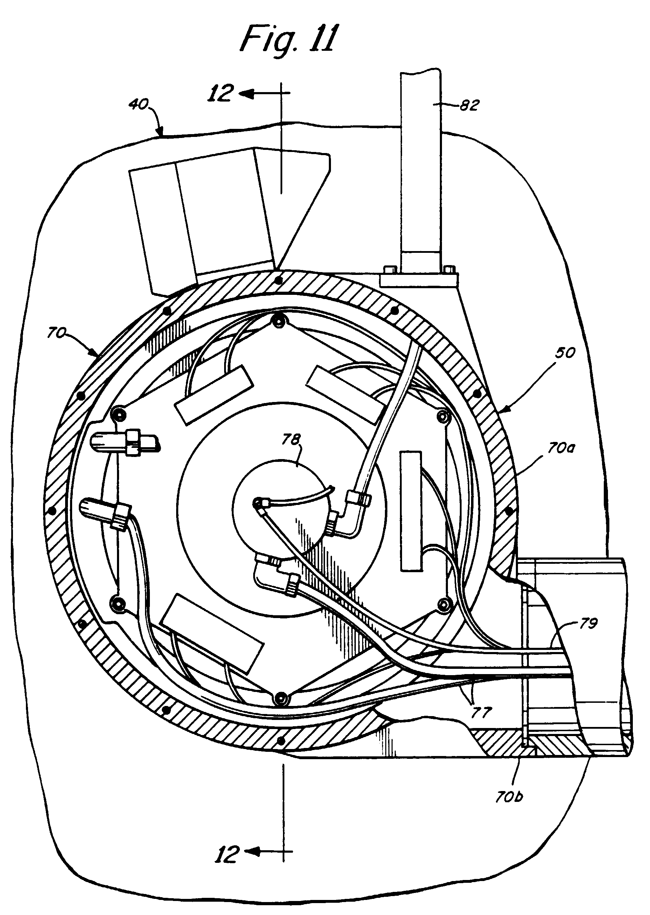

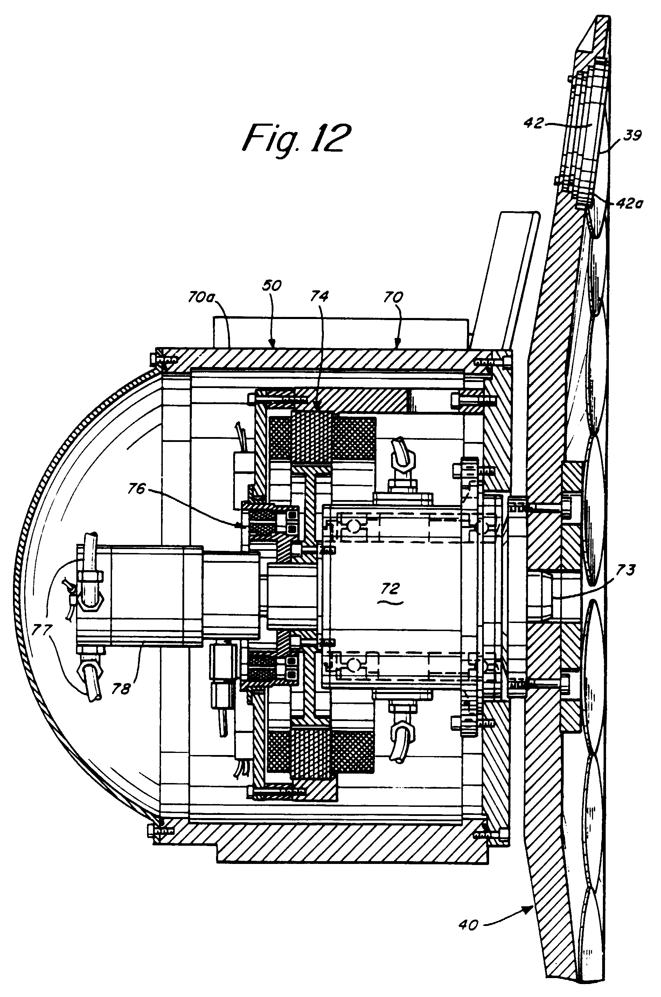

The disk 40 is mounted at its hub to the disk drive assembly 50. As shown in FIGS. 11 and 12, the disk drive assembly 50 includes a disk drive housing 70 that is sealed vacuum-tight so that the interior thereof can be maintained at atmospheric pressure. The disk drive housing 70 contains a rotary vacuum feedthrough 72, such as a magnetic fluid type, that transmits rotary motion and cooling water from the interior of the disk drive housing 70 into the vacuum chamber 30. The hub of the disk 40 is coupled to a shaft 73 of the rotary vacuum feedthrough 72 in the vacuum chamber 30. A disk drive motor 74 is coupled directly to the shaft 73 of the rotary vacuum feedthrough 72 within the disk drive housing 70. The disk drive motor 74 can be an a.c. frameless torque ring motor. Also coupled to the shaft 73 are a resolver 76 for monitoring the angular position of the disk 40 and a rotary union 78 for coupling cooling water to the wafer mounting sites 42. The cooling passages through disk 40 are omitted from the drawing.

The scan arm assembly 44 has a hollow, sealed interior that connects the interior of the disk drive housing 70 to the external atmosphere. Hoses 77 for cooling water and electrical cables 79 for carrying power to disk drive motor 74 and signals to resolver 76 pass through the scan arm assembly 44. By sealing the interior of disk drive housing 70, contaminants generated by the disk drive motor 74 and the other moving parts of the disk drive assembly 50 are prevented from entering the vacuum chamber 30 where they could contaminate the semiconductor wafers being implanted. A water-cooled spillover cup 80 is supported from the disk drive housing 70 by a pipe 82. The spillover cup 80 is positioned to collect any portion of the ion beam 20 that bypasses the edge of disk 40.

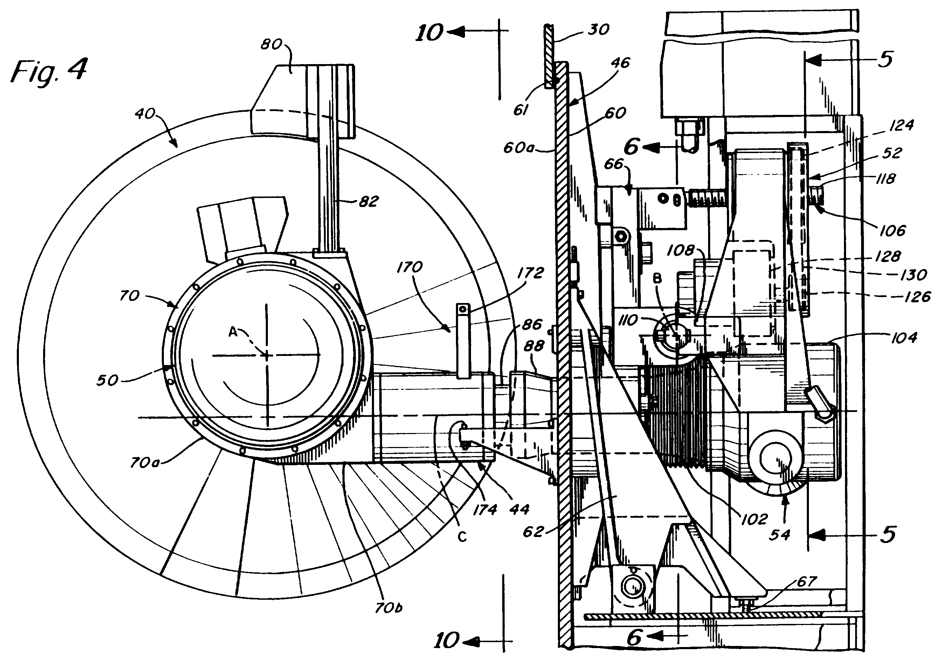

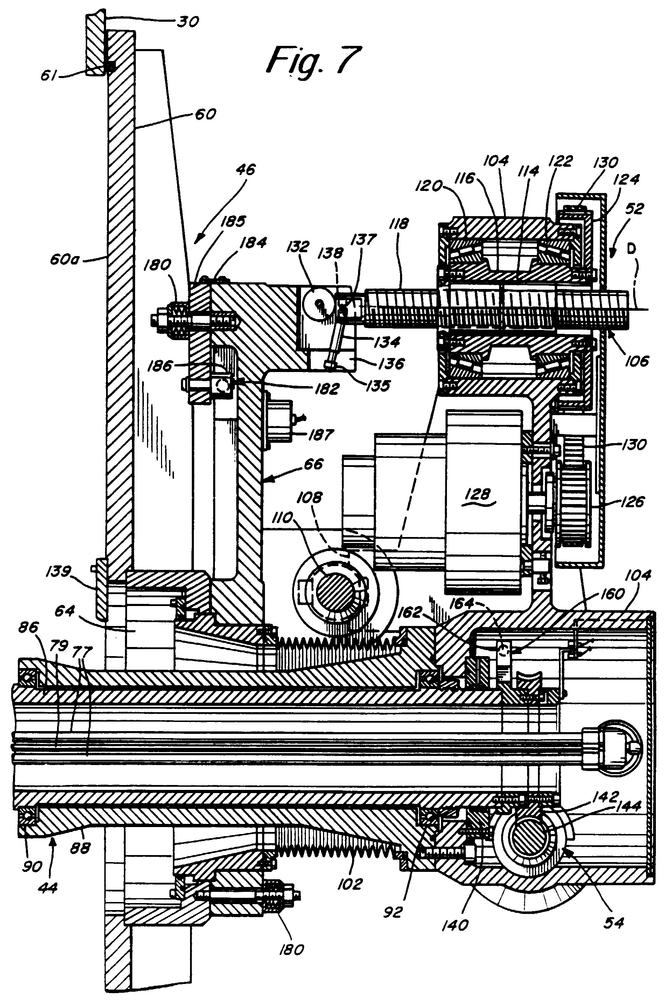

The disk drive housing 70 includes a first hollow portion 70a coaxial with disk rotation axis A and a second hollow portion 70b extending from hollow portion 70a and coaxial with pivot axis C. As shown in FIGS. 4 and 7, the scan arm assembly 44 includes a scan arm 86 that is sealed to and supports the second hollow portion 70b, and a scan arn housing 88. The scan arm 86 is mounted in the scan arm housing 88 with ball bearings 90, 92 so that the scan arm 86 can be rotated about axis C relative to scan arm housing 88. The scan arm 86 and the scan arm housing 88 extend through opening 64 in disk access door 60. The opening 64 is sealed by a bellows 102 that is coupled at one end to scan arm housing 88 and is coupled at the other end to scan support 66. The bellows 102 permits movement of the scan arm assembly 44 relative to access door 60 while maintaining high vacuum in chamber 30. The scan arm housing 88 is coupled at the end outside the vacuum chamber 30 to the scan drive assembly 52.

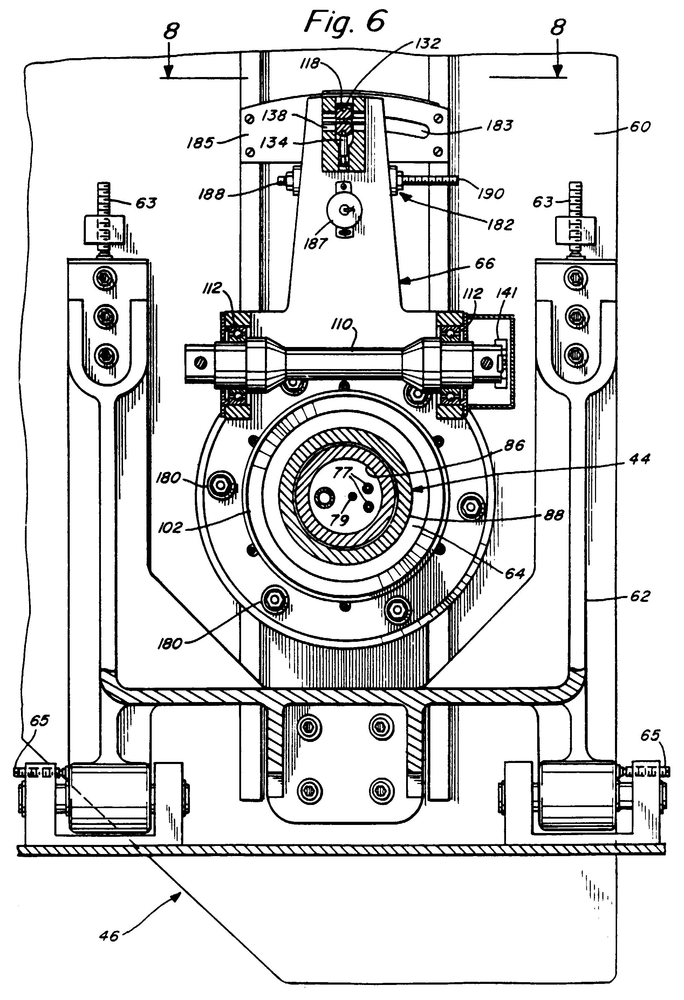

The scan drive assembly 52, as shown in FIGS. 4, 5 and 7, includes a scan drive housing 104 with a lower portion coupled to scan arm housing 88. The scan drive housing 104 extends upwardly from the scan arm housing 88 and provides means for mounting a ball screw assembly 106 in spaced-apart relationship to scan arm housing 88. The ball screw assembly 106 is mounted with an axis D parallel to and spaced apart from pivot axis C. The scan drive housing 104 further includes a pair of aligned V-blocks 108 positioned for engagement with a scan shaft 110 that is mounted to scan support 66 by ball bearings 112 (see FIG. 6) to permit rotation about scan axis B. The scan arm assembly 44 and the scan drive assembly 52 pivot about axis B on scan shaft 110 by operation of the ball screw assembly 106, as described hereinafter

The ball screw assembly 106 includes a nut 114 mounted in a sleeve 116. A ball screw 118 extends through the nut 114. The nut 114 and sleeve 116 are mounted to scan drive housing 104 by means of bearings 120, 122 which permit rotation of nut 114 about axis D. A pulley 124 is attached to the sleeve 116, and a pulley 126 is attached to the shaft of a scan motor 128. The scan motor 128 is mounted to scan drive housing 104, and the pulleys 124 and 126 are interconnected by a timing belt 130. When scan motor 128 is energized, pulley 124, sleeve 116 and nut 114 are caused to rotate.

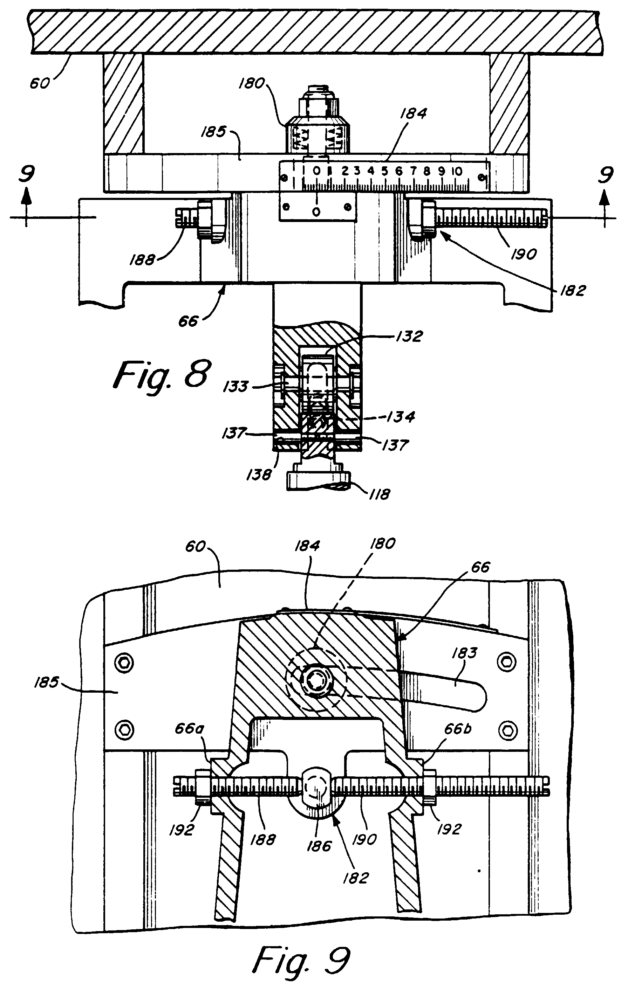

One end of ball screw 118 bears against a roller 132 that is rotatably mounted to scan support 66 by a pin 133. The ball screw 118 is also coupled by an antirotation pin 134 to scan support 66. A roller 135 attached to antirotation pin 134 is movable in an elongated, narrow slot 136 in scan support 66. The roller 132 permits slight movement of ball screw 118 transverse to axis D when the scan motor 128 is in operation. As shown in FIGS. 7 and 8, pins 137 are attached to ball screw 118. The pins 137, which are movable in elongated slots 138, do not function during normal operation. When the disk 40 is removed for service or exchange of disks, the pins 137 hold the scan drive assembly 52 in position and prevent it from rotating about axis B, due to the change in weight.

The weight of disk drive assembly 50 and disk 40 causes the scan arm assembly 44 to pivot downwardly about scan axis B and brings ball screw 118 into contact with roller 132. As a result, ball screw 118 remains in a substantially stationary axial position when the scan motor 128 is in operation. When scan motor 128 is energized, nut 114 rotates on stationary ball screw 118 and moves along axis D, thereby causing the scan arm assembly 44, the disk 40, the disk drive assembly 50 and the scan drive assembly 52 to rotate on scan shaft 110.

The rotation of the scan arm assembly 44 about scan shaft 110 is typically about ±12° for large wafers and is less for small wafers. A stop 139 (FIG. 7) mounted to door 60 limits the upward travel of scan arm assembly 44. In order to provide uniform distribution of the ion beam 20 over the wafer surface, the scan speed is controlled such that dR/dt is proportional to 1/R, where R is the distance from the disk axis A to the beam 20 in a direction perpendicular to the disk axis A.

Sensing switches 141 (FIG. 6) sense the rotational position of the scan arm assembly 44 about axis B. The sensing switches 141 sense the upper and lower limits of the scan and also sense the horizontal position of the scan arm assembly 44 in which the disk 40 is pivoted between the implant position and the load/unload position.

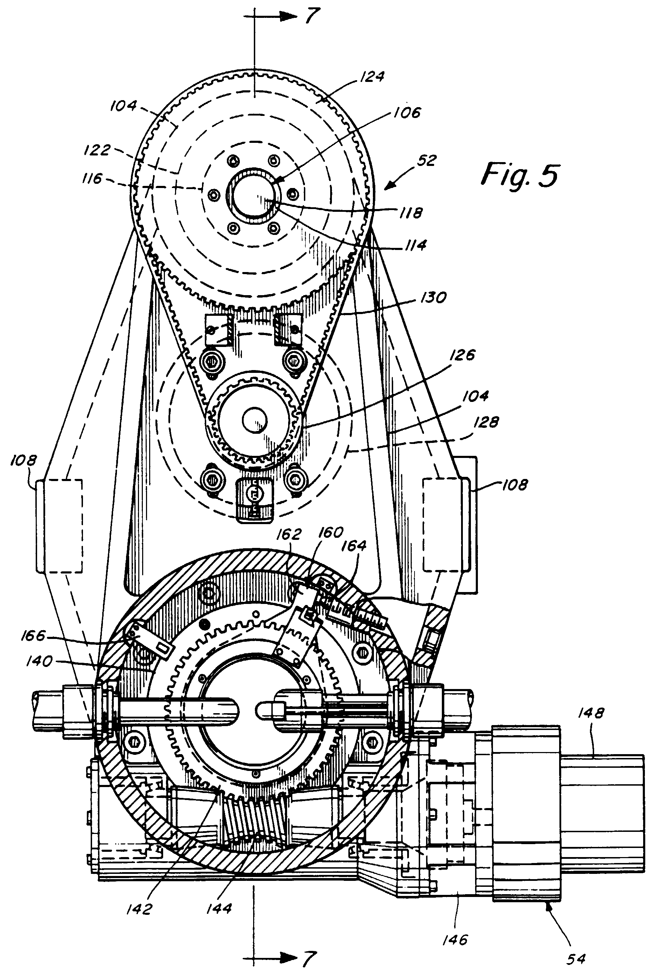

Pivot drive assembly 54 is mounted in the scan drive housing 104 adjacent the outer end of scan arm 86, as shown in FIGS. 5 and 7. A rotary vacuum seal 140, typically including two O-rings with an oil seal between them, permits rotary motion of scan arm 86 about axis C to be transmitted into vacuum chamber 30 while insuring that high vacuum is maintained. A worm gear 142 is attached to the scan arm 86 near its outer end. A worm 144 interengages with the worm gear 142 and is coupled by means of a speed reducer 146 to the shaft of a pivot drive motor 148 mounted on the scan drive housing 104.

The pivot drive assembly 54 is utilized during loading and unloading of wafers to pivot the disk from the approximately vertical implant position to the approximately horizontal load/unload position. After exchange of wafers, the disk 40 is pivoted back to the implant position. In order to load or unload wafers from the disk 40, the scan motor 128 is stopped with the scan arm assembly 44 horizontal. The pivot drive motor 148 is then energized, causing rotation of the worm 144 and worm gear 142. Scan arm 86 and disk drive assembly 50 thereby rotate about axis C, causing the disk 40 to pivot to the load/unload position (shown in FIG. 10 in phantom lines). In the load/unload position, one wafer mounting site 42 at a time is positioned adjacent to the wafer transfer system 38 which loads and unloads wafers 39 from that site. The wafers 39 are moved between cassettes 150 (FIGS. 1 and 10) and the wafer mounting site 42 by an articulated arm 152. After wafer exchange is completed at one wafer mounting site 42, the disk drive motor 74 indexes the disk 40 to the next wafer mounting site 42, and the wafer exchange process is repeated. A suitable wafer transfer system is disclosed in application Serial No. 135,568 filed December 21, 1987, which is hereby incorporated by reference. After the wafers have been exchanged on all of the mounting sites 42, the pivot drive motor 148 is energized in the opposite direction, and the disk 40 is pivoted around axis C to the implant position. During operation of the pivot drive motor 148, the scan arm housing 88 remains stationary, and the scan arm 86 rotates in ball bearings 90 and 92.

As noted above, it is desirable that the ion implanter have the capability of changing the implant angle, the angle of incidence of ion beam 20 on the wafer. Typically, implant angles range from normal incidence to about 10° from normal incidence. In accordance with one aspect of the present invention, the implant angle can be changed by a single adjustment that is made external to the vacuum chamber 30 without opening or venting vacuum chamber 30. Before considering implant angle adjustment, it is useful to discuss the interrelationship between the disk rotation axis A, the scan axis B and the axis of the ion beam 20.

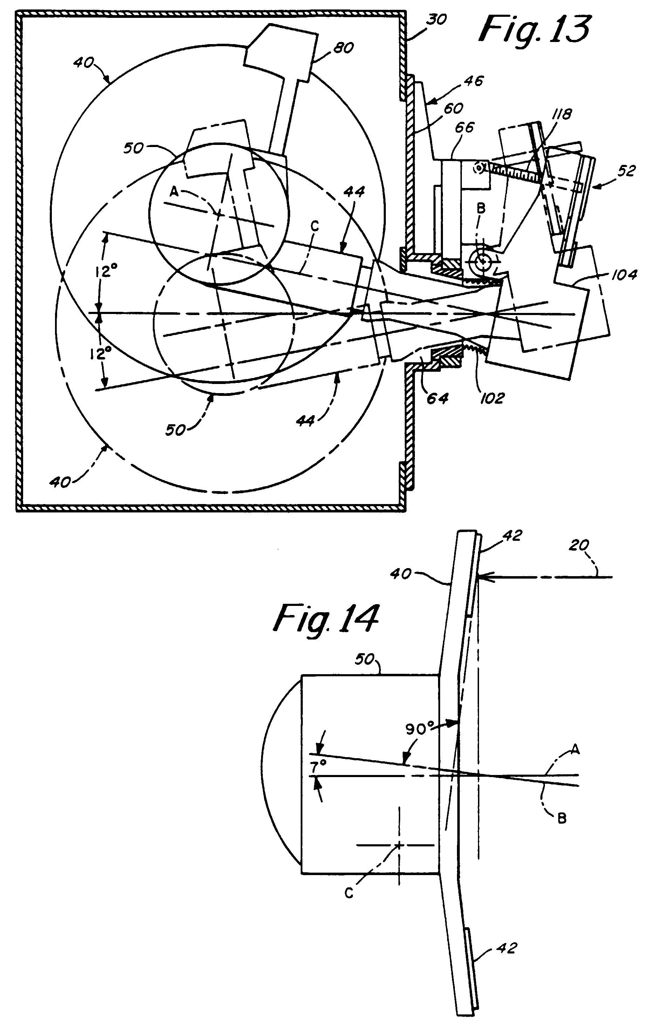

It is desirable during scanning to maintain the point of incidence of the ion beam 20 on the wafer surface fixed along the ion beam axis in order to insure dose uniformity. This condition is met by establishing the scan axis B perpendicular to the plane of the wafer mounting site 42 that is intercepting the ion beam 20. In a preferred embodiment, the wafer mounting sites 42 are oriented at an angle of 7° relative to the plane of disk 40, and the scan axis B is oriented at an angle of 7° relative to the disk rotation axis A, as shown in FIG. 14. In FIGS. 1-13, the angle between the A axis and the B axis is omitted for clarity. The relationship between axes A and 8 remains fixed when the implant angle is changed. From FIG. 14 it can be seen that as the disk 40 is scanned about the B axis, that mounting site 42 which is intercepting the ion beam 20 moves transversely in its own plane.

The angle between the A and B axes is established by an adjustable stop assembly 160 (FIG. 5) mounted to the scan arm 86 and to the scan drive housing 104. The adjustable stop assembly 160 includes a stop lever 162 radially mounted at a predetermined angular position on the scan arm 86 and an adjustable stop 164 mounted on the scan drive housing 104. As the scan arm 86 rotates about axis C, the stop lever 162 and the stop 164 contact each other when the disk 40 reaches the implant position. The stop 164 is an axially adjustable screw which permits the angle between the A and B axes to be accurately adjusted so that the scan axis B is perpendicular to the plane of the wafer which is intercepting ion beam 20. The pivot drive motor 148 is preferably a type, such as an a.c. servomotor, which provides torque sensing. When the stop lever 162 rotates into contact with stop 164, the torque supplied by motor 148 increases. The increased torque is sensed, and the motor is deenergized. As a result, when the disk 40 is returned to the implant position, the desired angle between the disk rotation axis A and the scan axis B is established, regardless of implant angle adjustment, as described hereinafter.

The load/unload position of the disk 40 is established by a stop assembly 170 mounted on the disk drive housing 70 and on the access door 60, as shown in FIGS. 4 and 10. A stop lever 172 is mounted with a radial orientation on the second portion 70b of disk drive housing 70. A stop 174 is mounted to access door 60. The stop lever 172 and the stop 174 are positioned to contact each other when the disk 40 rotates about axis C to a position wherein the wafer mounting site 42 at the top of disk 40 is horizontal and is aligned with the wafer transfer system. The stop assembly 170 establishes a fixed relationship between the disk 40 and the wafer transfer system 38, regardless of the implant angle adjustment. Thus, adjustment of the wafer transfer system is not necessary when the implant angle is changed. A stop lever 166 (FIG. 5) is mounted to housing 104 so as to contact stop lever 162 at a second angular position corresponding to the load/unload position. The stop lever 166 causes the motor 148 to be deenergized when the disk 40 has almost reached the load/unload position.

The implant angle is changed by rotating virtually the entire scanning apparatus 36 around the axis C. The scan support 66 is mounted to access door 60 by a plurality of spring-loaded clamps 180 (FIGS. 6 and 8). When it is desired to change the implant angle, the spring-loaded clamps 180 are loosened, and the scan support 66 is rotated about the axis C by operation of a screw adjustment assembly 182. The spring-loaded clamps 180 move in elongated, arc-shaped slots 183. The scan support 66 carries with it the scan drive assembly 52, the scan arm assembly 44, the disk drive assembly 50 and the disk 40 so that the angle of the wafer mounting site 42 relative to ion beam 20 is changed. The exact implant angle is determined by graduations 184 on a mounting bracket 185 attached to the access door 60, and on the scan support 66. When the desired implant angle is reached, the spring-loaded clamps 180 are retightened. Thus, the implant angle is adjusted without the necessity of opening or venting the vacuum chamber 30, and the desired relationship between disk rotation axis A and scan axis B is maintained constant. An inclinometer 187 (FIG. 7) attached to scan support 66 provides a signal representative of the implant angle to the ion implantation system computer.

The adjustment assembly 182 is illustrated in FIG. 9. A pin 186, having flat sides, is attached to the mounting bracket 185. An adjustment screw 188 is threaded through a first portion 66a of the scan support 66 and abuts one side of pin 186. An adjustment screw 190 is threaded through a second portion 66b of scan support 66 and abuts against the opposite side of pin 186. When the spring-loaded clamps 180 are loosened, the implant angle is adjusted by retracting one of the adjustment screws 188 or 190 and advancing the other adjustment screw, so that the scan support 66 is caused to rotate about axis C. The implant angle is read from graduations 184. When the desired implant angle is reached, both adjustment screws 188, 190 are tightened against pin 186 and check nuts 192 are tightened against scan support 66 to maintain adjustment screws 188 and 190 in position. Then, the spring-loaded clamps 180 are tightened. The adjustment of implant angle without opening or venting the vacuum chamber 30 provides a considerable time saving over prior art methods of implant angle adjustment.

## Claims

1. Apparatus for workpiece translation, comprising a vacuum envelope defining a vacuum chamber (30); a disk (40) including a plurality of workpiece mounting sites (42), said disk being positioned within said vacuum chamber; disk drive means (50) within said vacuum chamber for rotating said disk about a disk rotation axis (A); and pivot drive means (54) for pivoting said disk drive means and said disk about a pivot axis (C) to and between a treatment position and a load/unload position for loading and unloading of workpieces characterised by scan arm means (44) for supporting said disk and said disk drive means, said scan arm means extending through said vacuum envelope and being mounted for movement around a scan axis (B); and scan drive means (52) for scanning said scan arm means about said scan axis so that said disk and said disk drive means move along an arc-shaped path in said vacuum chamber, said pivot drive means pivoting said scan arm means with said disk drive means and said disk about said pivot axis (C) which is perpendicular to said disc rotation axis (A).

2. Apparatus as claimed in claim 1 comprising means (10) for generating an ion beam (20) which intercepts successive of said workpiece mounting sites (42) as said disk is rotated about a disk rotation axis.

3. Apparatus as claimed in claim 1 or claim 2 for use with wafer workpieces, each mounting site including a generally planar wafer mounting surface, said wafer mounting surfaces each being oriented at a predetermined angle relative to a plane perpendicular to said disk rotation axis and said scan axis being oriented at said predetermined angle relative to said disk rotation axis so that said scan axis is perpendicular to the wafer mounting surface of said one of said wafer mounting sites that intercepts said ion beam.

4. Apparatus as claimed in any one of the preceding claims wherein said pivot drive means includes means for changing the angle of incidence of said ion beam on said mounting surface and includes means for rotating said disk, said disk drive means and said scan arm means around an axis parallel to the plane of said disk without opening said vacuum chamber.

5. Workpiece translation apparatus as claimed in any one of the preceding claims wherein said vacuum envelope includes an access door and wherein said apparatus further includes scan support means attached to said access door for mounting said scan drive means so that said scan drive means, said scan arm means, said disk drive means and said disk are supported from and carried by said access door.

6. Apparatus as claimed in claim 5 including means for carrying said access door to and between a closed operational position and an open access position.

7. Apparatus as claimed in claim 5 or claim 6 wherein said scan arm means extends through an opening in said access door and wherein said opening is sealed with a bellows having one end sealed to said scan arm means.

8. Apparatus as claimed in any one of the preceding claims wherein each mounting site includes a generally planar workpiece mounting surface.

9. Apparatus as claimed in any one of the preceding claims wherein said scan axis is located outside said vacuum envelope.

10. Apparatus as claimed in any one of the preceding claims wherein said disk drive means includes a sealed disk drive housing enclosing a disk drive motor and said scan arm means includes a hollow portion for coupling the interior of said disk drive housing to the external atmosphere, whereby the interior of said disk drive housing is maintained at ambient pressure and is isolated from said vacuum chamber.

11. Apparatus as claimed in any one of the preceding claims wherein said pivot axis is parallel to the plane of said disk.

12. Apparatus as claimed in any one of the preceding claims wherein said scan drive means comprises a ball screw assembly including a ball screw having one end in abutting contact with one of said scan support means and said scan drive means and a nut mounted for rotational movement to the other of said scan support means and said scan drive means, and a scan drive motor coupled to said nut for advancing said nut on said ball screw, whereby said scan drive means and said scan arm means pivot around said scan axis when said scan drive motor is energized.

13. Apparatus as claimed in any one of the preceding claims wherein said scan arm means comprises a scan arm housing on said pivot axis and a scan arm that is coaxial with said scan arm housing, said scan arm being mounted for rotation around said pivot axis relative to said scan arm housing.

14. Apparatus as claimed in any one of the preceding claims wherein said pivot drive means comprises a pivot drive motor and means for coupling said pivot drive motor to said scan arm so that said scan arm, said disk drive means and said disk are pivoted around said pivot axis when said pivot drive motor is energized.

15. Apparatus as claimed in any one of the preceding claims further including implant angle adjustment means for rotating said scan support means around said pivot axis without opening or venting said vacuum chamber, whereby the angle of incidence of said ion beam on said workpiece mounting surface is changed while maintaining said workpiece mounting surface substantially perpendicular to said scan axis.

16. Apparatus as claimed in claim 15 when dependent on any one of claims 5 to 7 wherein said implant angle adjustment means includes means for rotating said scan support means relative to said access door.

17. Apparatus as claimed in any one of the preceding claims further including stop means for establishing the relative alignment of said disk rotation axis and said scan axis, said stop means including a stop lever radially mounted to said scan arm and a stop mounted to one of said scan drive means and said scan arm housing so that said stop lever and said stop contact each other when said disk rotation axis and said scan axis have the desired relative orientation.

18. Apparatus as claimed in any one of claims 1 to 16 further including stop means for establishing the alignment of said disk in said load/unload position, said stop means including a stop lever mounted to said disk drive means and a stop mounted to said access door so that said stop lever and said stop contact each other when said disk reaches the desired load/unload position.

## Patentansprüche

1. Vorrichtung zur Werkstückverschiebung, umfassend einen eine Vakuumkammer (30) definierenden Vakuumkolben; eine Scheibe (40) einschließlich einer Vielzahl von Werkstückbefestigungsstellen (42), wobei die Scheibe in der Vakuumkammer angeordnet ist; Scheibenantriebsmittel (50) in der Vakuumkammer zum Drehen der Scheibe um eine Scheibenrotationsachse (A); und Drehantriebsmittel (54) zum Drehen des Scheibenantriebsmittels und der Scheibe um eine Drehachse (C) zu einer und zwischen einer Bearbeitungsposition und einer Belade/Entladeposition zum Be- und Entladen von Werkstücken, gekennzeichnet durch Scannerarmmittel (44) zum Tragen der Scheibe und des Scheibenantriebsmittels, wobei sich das Scannerarmmittel durch den Vakuumkolben erstreckt und zur Bewegung um eine Scannerachse (B) befestigt ist; und Scannerantriebsmittel (52) zum Drehen des Scannerarmmittels um die Scannerachse, so daß die Scheibe und das Scheibenantriebsmittel sich entlang eines bogenförmigen Weges in der Vakuumkammer bewegen, wobei das Drehantriebsmittel das Scannerarmmittel mit dem Scheibenantriebsmittel und der Scheibe um die Drehachse (C) dreht, die senkrecht zu der Scheibenrotationsachse (A) ist.

2. Vorrichtung nach Anspruch 1, die Mittel (10) zum Erzeugen eines lonenstrahles (20) umfaßt, der aufeinanderfolgend von den Werkstückbefestigungsstellen (42) aufgefangen wird, wenn die Scheibe um eine Scheibenrotationsachse gedreht wird.

3. Vorrichtung nach Anspruch 1 oder 2 zur Anwendung bei Halbleiterplättchenwerkstücken, wobei jede Befestigungsstelle eine im wesentlichen ebene Halbleiterplättchenbefestigungsfläche umfaßt, die Halbleiterplättchenbefestigungsflächen jeweils in einem vorgegebenen Winkel in bezug auf eine zu der Scheibenrotationsachse senkrechten Ebene ausgerichtet sind und die Scannerachse in dem vorgegebenen Winkel in bezug auf die Scheibenrotationsachse ausgerichtet ist, so daß die Scannerachse senkrecht zu der Halbleiterplättchenbefestigungsfläche derjenigen Halbleiterplättchenbefestigungsstelle ist, die den lonenstrahl auffängt.

4. Vorrichtung nach einem der vorhergehenden Ansprüche, bei der das Drehantriebsmittel Mittel zum Verändern des Einfallwinkels des lonenstrahles auf die Befestigungsfläche und Mittel zum Drehen der Scheibe, des Scheibenantriebsmittels und des Scannerarmmittels um eine zu der Ebene der Scheibe parallele Achse ohne Öffnen der Vakuumkammer umfaßt.

5. Werkstückverschiebungsvorrichtung nach einem der vorhergehenden Ansprüche, bei der der Vakuumkolben eine Zugangstür und die Vorrichtung desweiteren Scannerträgermittel umfaßt, die an der Zugangtür zum Befestigen des Scannerantriebsmittels befestigt sind, so daß das Scannerantriebsmittel, das Scannerarmmittel, das Scheibenantriebsmittel und die Scheibe von der Zugangstür aufgenommen und durch diese getragen werden.

6. Vorrichtung nach Anspruch 5, einschließlich von Mitteln zum Führen der Zugangstür zu und zwischen einer geschlossenen Arbeitsposition und einer offenen Zugangsposition.

7. Vorrichtung nach Anspruch 5 oder 6, bei der sich das Scannerarmmittel durch eine Öffnung in der Zugangstür erstreckt und die Öffnung mit einem Faltenbalg abgedichtet ist, dessen eines Ende an dem Scannerarmmittel abgedichtet ist.

8. Vorrichtung nach einem der vorhergehenden Ansprüche, bei der jede Befestigungsstelle eine im wesentlichen ebene Werkstückbefestigungsfläche besitzt.

9. Vorrichtung nach einem der vorhergehenden Ansprüche, bei der die Scannerachse außerhalb des Vakuumkolbens gelegen ist.

10. Vorrichtung nach einem der vorhergehenden Ansprüche, bei der das Scheibenantriebsmittel ein abgedichtetes Scheibenantriebsgehäuse, das einen Scheibenantriebsmotor aufnimmt, und das Scannerarmmittel ein hohles Teil zum Verbinden des Inneren des Scheibenantriebsgehäuses mit der Außenatmosphäre umfaßt, wobei das Innere des Scheibenantriebsgehäuses auf Umgebungsdruck gehalten wird und von der Vakuumkammer isoliert ist.

11. Vorrichtung nach einem der vorhergehenden Ansprüche, bei der die Drehachse parallel zu der Ebene der Scheibe ist.

12. Vorrichtung nach einem der vorhergehenden Ansprüche, bei der das Scannerantriebsmittel eine Kugelspindelanordnung einschließlich einer Kugelspindel mit einem entweder an das Scannerträgermittel oder das Scannerantriebsmittel stoßenden Ende und einer Mutter, die zur Drehbewegung zu dem anderen Scannerträgermittel oder Scannerantriebsmittel befestigt ist, und einen Scannerantriebsmotor umfaßt, der mit der Mutter verbunden ist, um die Mutter auf der Kugelspindel voranzutreiben, wodurch das Scannerantriebsmittel und das Scannerarmmittel um die Scannerachse drehen, wenn der Scannerantriebsmotor eingeschaltet ist.

13. Vorrichtung nach einem der vorhergehenden Ansprüche, bei der das Scannerarmmittel ein Scannerarmgehäuse auf der Drehachse und einen Scannerarm umfaßt, der koaxial mit dem Scannerarmgehäuse ist, wobei der Scannerarm zur Rotation um die Drehachse in bezug auf das Scannerarmgehäuse befestigt ist.

14. Vorrichtung nach einem der vorhergehenden Ansprüche, bei der das Drehantriebsmittel einen Drehantriebsmotor und Mittel zum Verbinden des Drehantriebsmotors mit dem Scannerarm umfaßt, so daß der Scannerarm, das Scheibenantriebsmittel und die Scheibe um die Drehachse gedreht werden, wenn der Drehantriebsmotor eingeschaltet ist.

15. Vorrichtung nach einem der vorhergehenden Ansprüche, die außerdem ein Implantationswinkeleinstellmittel zum Drehen des Scannerträgermittels um die Drehachse ohne Öffnen oder Belüften der Vakuumkammer umfaßt, wodurch der Einfallwinkel des lonenstrahles auf die Werkstückbefestigungsfläche verändert wird, während die Werkstückbefestigungsfläche im wesentlichen senkrecht zu der Scannerachse gehalten wird.

16. Vorrichtung nach Anspruch 15 bei Abhängigkeit von einem der Ansprüche 5 bis 7, bei der das Implantationswinkeleinstellmittel Mittel zum Drehen des Scannerträgermittels in bezug auf die Zugangstür umfaßt.

17. Vorrichtung nach einem der vorhergehenden Ansprüche, die außerdem Anschlagmittel zum Herstellen der relativen Ausrichtung der Scheibenrotationsachse und der Scannerachse umfaßt, wobei das Anschlagmittel einen radial an dem Scannerarm befestigten Arretierhebel und einen entweder an dem Scannerantriebsmittel oder dem Scannerarmgehäuse befestigten Anschlag umfaßt, so daß der Arretierhebel und der Anschlag einander berühren, wenn die Scheibenrotationsachse und die Scannerachse die gewünschte relative Ausrichtung haben.

18. Vorrichtung nach einem der Ansprüche 1 bis 16, die außerdem Anschlagmittel zum Herstellen der Ausrichtung der Scheibe in der Belade/Entladeposition umfaßt, wobei das Anschlagmittel einen an dem Scheibenantriebsmittel befestigten Arretierhebel und einen an der Zugangstür befestigten Anschlag umfaßt, so daß der Arretierhebel und der Anschlag einander berühren, wenn die Scheibe die gewünschte Belade/Entladeposition erreicht.

## Revendications

1. Appareil servant à transférer des pièces et comprenant :
- une enveloppe sous vide qui définit une chambre à vide (30),
- un disque (40) comprenant une pluralité de sites (42) de montage de pièces, ledit disque étant situé à l'intérieur de ladite chambre à vide,
- un moyen (50) d'entraînement du disque situé à l'intérieur de la chambre à vide et servant à faire tourner ledit disque autour d'un axe (A) de rotation du disque et,
- un moyen (54) d'entraînement de pivotement, servant à faire pivoter ledit moyen d'entraînement du disque et ledit disque autour d'un axe ( C) de pivotement vers et entre une position de traitement et une position de chargement et de déchargement afin de charger et décharger les pièces,
**caractérisé** par:
- un moyen (44) formant un bras de balayage qui supporte ledit disque et ledit moyen d'entraînement du disque, ledit moyen formant un bras de balayage traversant ladite enveloppe sous vide et étant monté de façon à pouvoir se déplacer autour d' un axe de balayage (B) et,
- un moyen (52) d'entraînement du dispositif de balayage servant à faire balayer ledit moyen formant un bras de balayage autour dudit axe de balayage, de sorte que ledit disque et ledit moyen d'entraînement du disque se déplacent suivant un trajet en forme d'arc dans ladite chambre à vide, ledit moyen d'entraînement de pivotement faisant pivoter ledit moyen formant un bras de balayage avec ledit moyen d'entraînement du disque et ledit disque autour dudit axe de pivotement ( C) qui est perpendiculaire audit axe (A) de rotation du disque.

2. Appareil selon la revendication 1, comprenant un moyen (10) servant à produire un faisceau ionique (20) qui intercepte des sites successifs (42) de montage de pièces, au fur et à mesure que ledit disque est tourné autour d'un axe de rotation de celui-ci.

3. Appareil selon la revendication 1 ou la revendication 2, destiné à être utilisé avec des pièces formant des tranches, chaque site de montage comprenant une surface de montage des tranches globalement plane, lesdites surfaces de montage des tranches étant toutes orientées sous un angle prédéterminé par rapport à un plan perpendiculaire audit axe de rotation du disque et ledit axe de balayage étant orienté sous ledit angle prédéterminé par rapport audit axe de rotation du disque, de sorte que ledit axe de balayage est perpendiculaire à la surface de montage des tranches de l'un desdits sites de montage des tranches qui intercepte ledit faisceau ionique.

4. Appareil selon l'une quelconque des revendications précédentes, dans lequel ledit moyen d'entraînement de pivotement comprend des moyens pour modifier l'angle d'incidence dudit faisceau ionique sur ladite surface de montage, et comprend des moyens pour faire tourner ledit disque, ledit moyen d'entraînement du disque et ledit moyen formant un bras de balayage autour d'un axe parallèle au plan dudit disque sans ouvrir ladite chambre à vide.

5. Appareil pour le transfert de pièces selon l'une quelconque des revendications précédentes, dans lequel ladite enveloppe sous vide comporte une porte d'accès, et dans lequel ledit appareil comprend en outre un moyen formant un support de balayage fixé à ladite porte d'accès et servant à monter ledit moyen d'entraînement du dispositif de balayage, de sorte que ledit moyen d'entraînement du dispositif de balayage, ledit moyen formant un bras de balayage, ledit moyen d'entraînement du disque et ledit disque sont supportés par ladite porte d'accès et transportés par celle-ci.

6. Appareil selon la revendication 5, comprenant des moyens pour amener ladite porte d'accès à une position fermée d'utilisation et à une position ouverte d'accès et entre ces deux positions.

7. Appareil selon la revendication 5 ou la revendication 6, dans lequel ledit moyen formant un bras de balayage traverse une ouverture formée dans ladite porte d'accès, et dans lequel ladite ouverture est obturée par un soufflet dont l'une des extrémités est réunie de manière étanche audit moyen formant un bras de balayage.

8. Appareil selon l'une quelconque des revendications précédentes, dans lequel chaque site de montage comporte une surface de montage des pièces globalement plane.

9. Appareil selon l'une quelconque des revendications précédentes, dans lequel ledit axe de balayage est situé à l'extérieur de ladite enveloppe sous vide.

10. Appareil selon l'une quelconque des revendications précédentes, dans lequel ledit moyen d'entraînement du disque comprend un carter rendu étanche d'entraînement du disque renfermant un moteur d'entraînement du disque, et ledit moyen formant un bras de balayage comporte une partie creuse servant à relier l'intérieur dudit carter d'entraînement du disque à l'atmosphère extérieure, grâce à quoi l'intérieur dudit carter d'entraînement du disque est maintenu à la pression ambiante et est isolé de ladite chambre à vide.

11. Appareil selon l'une quelconque des revendications précédentes, dans lequel ledit axe de pivotement est parallèle au plan dudit disque.

12. Appareil selon l'une quelconque des revendications précédentes, dans lequel ledit moyen d'entraînement du dispositif de balayage comprend un ensemble de vis à billes comportant une vis à billes dont l'une des extrémités est en contact de butée avec l'un dudit moyen formant un support de balayage ou dudit moyen d'entraînement du dispositif de balayage, et un écrou monté de façon à permettre son mouvement rotatoire vers l'autre dudit moyen formant un support de balayage ou dudit moyen d'entraînement du dispositif de balayage, et un moteur d'entraînement du dispositif de balayage couplé audit écrou pour faire avancer ledit écrou sur ladite vis à billes, grâce à quoi ledit moyen d'entraînement du dispositif de balayage et ledit moyen formant un bras de balayage pivotent autour dudit axe de balayage lorsque ledit moteur d'entraînement du dispositif de balayage est excité.

13. Appareil selon l'une quelconque des revendications précédentes, dans lequel ledit moyen formant un bras de balayage comprend un carter pour le bras de balayage qui est placé sur ledit axe de pivotement et un bras de balayage qui est coaxial avec ledit carter du bras de balayage, ledit bras de balayage étant monté de façon à pouvoir tourner autour dudit axe de pivotement par rapport audit carter du bras de balayage.

14. Appareil selon l'une quelconque des revendications précédentes, dans lequel lesdits moyens d'entraînement du dispositif de pivotement comprennent un moteur d'entraînement de pivotement et un moyen pour coupler ledit moteur d'entraînement de pivotement audit bras de balayage, de sorte que ledit bras de balayage, ledit moyen d'entraînement du disque et ledit disque sont pivotés autour dudit axe de pivotement lorsque ledit moteur d'entraînement du dispositif de pivotement est excité.

15. Appareil selon l'une quelconque des revendications précédentes, comprenant en outre des moyens de réglage de l'angle d'implantation pour faire tourner ledit moyen formant un support de balayage autour dudit axe de pivotement sans ouvrir ni mettre à l'atmosphère ladite chambre à vide, grâce à quoi l'angle d'incidence dudit faisceau ionique sur ladite surface de montage des pièces est modifié, tout en maintenant ladite surface de montage des pièces sensiblement perpendiculaire audit axe de balayage.

16. Appareil selon la revendication 15 lorsqu'il dépend de l'une quelconque des revendications 5 à 7, dans lequel ledit moyen de réglage de l'angle d'implantation comprend des moyens pour faire tourner ledit moyen formant un support de balayage par rapport à ladite porte d'accès.

17. Appareil selon l'une quelconque des revendications précédentes, comprenant en outre des moyens d'arrêt servant à établir l'alignement relatif dudit axe de rotation du disque et dudit axe de balayage, lesdits moyens d'arrêt comprenant un levier d'arrêt monté radialement sur ledit bras de balayage et une butée montée sur l'un dudit moyen d'entraînement du dispositif de balayage ou dudit carter du bras de balayage, de sorte que ledit levier d'arrêt et ladite butée sont en contact l'un avec l'autre lorsque ledit axe de rotation du disque et ledit axe de balayage ont l'orientation relative souhaitée.

18. Appareil selon l'une quelconque des revendications 1 à 16, comprenant en outre des moyens d'arrêt servant à établir l'alignement dudit disque dans ladite position de chargement et de déchargement, lesdits moyens d'arrêt comprenant un levier d'arrêt monté sur ledit moyen d'entraînement du disque et une butée montée sur ladite porte d'accès, de sorte que ledit levier d'arrêt et ladite butée sont en contact l'un avec l'autre lorsque ledit disque atteint la position de chargement ou de déchargement souhaitée.
